# EUROPEAN PATENT SPECIFICATION

(11) **EP 2 301 043 B1**
(45) Date of publication and mention of the grant of the patent: **08.03.2017**
(21) Application number: 09774505.3
(22) Date of filing: 02.07.2009
(51) Int. Cl.: H05K 3/12, H05K 3/32

(54) **METALLIC PASTES AND INKS**
METALLISCHE PASTEN UND TINTEN
PÂTES ET ENCRES MÉTALLIQUES

(30) Priority: 02.07.2008 US 77711 P; 17.07.2008 US 81539 P; 01.07.2009 US 496453
(43) Date of publication of application: 30.03.2011
(73) Proprietor: Ishihara Chemical Co., Ltd., Kobe 652-0806 (JP)
(72) Inventor: YANG, Mohshi, Austin TX 78759 (US); ROUNDHILL, David, Max, Austin TX 78729 (US); YANIV, Zvi, Austin TX 78746 (US)
(74) Representative: Camenisch, Andrew Richard
(86) International application number: PCT/US2009/049510
(87) International publication number: WO 2010/003056

(56) References cited:
- US-A- 6 139 777
- US-A1- 2006 057 502
- US-A1- 2006 082 952
- US-A1- 2006 189 113
- US-A1- 2006 286 301
- US-A1- 2008 143 906
- US-B2- 6 783 569
- US-B2- 7 297 902

## Description

### TECHNICAL FIELD

This document relates to metallic pastes and inks that can be used to form metallic conductors with improved conductivity.

### BACKGROUND

Metallic pastes, like metallic inks, can be formulated with metal nanoparticles, liquid vehicles, dispersants, and other additives. Additives can be included to alter physical properties such as viscosity, wetting, and contact angle on chosen substrates. The higher viscosity of pastes (e.g., about 10,000 cP to about 60,000 cP) compared to inks (e.g., less than about 5000 cP) facilitates persistent dispersion of metal nanoparticles. Use of a metallic ink or paste can be based on a number of factors including printing method and substrate. Inks with a low viscosity (e.g., less than about 20 cP, or between about 10 cP and about 20 cP) may be ink-jet printed or aerosol printed. Pastes are too viscous to be ink-jet printed and may be applied by screen printing or other methods that are suitable for higher viscosities.

Some metallic pastes or inks, however, may require heating at elevated temperatures in an inert atmosphere-conditions which can be unsuitable for certain applications, such as flexible electronics (e.g., with polymeric substrates). Additionally, some metallic pastes or inks include one or more liquid components with a high boiling point. When a metallic paste or ink with a high boiling point component is cured by a slow thermal sintering process in air, the high boiling point components can form non-volatile products that remain in the cured conductor. Thermal decomposition to non-volatile products can also during thermal sintering in an inert atmosphere, yielding contaminated conductors and relatively high resistivity. In some cases, organic residues from the liquid vehicle degrade the adhesion between the conductor and the substrate, reducing the quality of the metallic conductor.

US 2006/0057502 discloses a method of making fine wirings having the steps of painting a board with metal dispersion colloid including metal nanoparticles of 0.5 nm-200 nm diameters, drying the metal dispersion colloid into a metal-suspension film, irradiating the metal-suspension film with a laser beam of 300nm-550 nm wavelengths, depicting arbitrary patterns on the film with the laser beam, aggregating metal nanoparticles into larger conductive grains, washing the laser-irradiated film, eliminating unirradiated metal nanoparticles, and forming metallic wiring patterns built by the conductive grains on the board. US 2006/0057502 also discloses an inexpensive apparatus to form fine arbitrary wiring patterns on boards without expensive photomasks, resists, exposure apparatus and etching apparatus. The method can make wirings also on plastic boards or low-melting-point glass boards which have poor resistance against heat and chemicals.

US 2006/0082952 discloses an electroconductive paste composition characterized in that an electroconductive powder with a mean grain size of 1 µm or less and a copolymer binder composed of tetrafluoroethylene, hexafluoropropylene, and vinylidene fluoride are dispersed in a solvent. The present invention provides an electroconductive paste. Composition that can be cured at low temperatures and can be endowed with low resistivity as a result of using a conventional mixing technique without the need for particularly expensive materials or techniques.

### BRIEF DESCRIPTION OF THE DRAWINGS

FIG. 1 is a flowchart that illustrates preparation of a metallic composition.
FIG. 2 is a flowchart that illustrates a process for forming metallic conductors by a process including photosintering.
FIG. 3 is a plot of resistivity vs. process temperature for copper conductors formed by thermal sintering and photosintering.
FIG. 4 illustrates an assembly having chips that are interconnected by printed conductors made from a metallic composition.
FIG. 5 illustrates an assembly having chips that are interconnected through vias by printed conductors made from a metallic composition.
FIG. 6 illustrates a wire secured to a photosintered metallic bump.
FIG. 7 is a flowchart that illustrates steps in a formation of a photosintered metallic bump.
FIG. 8 illustrates a metallic wire secured between photosintered metallic bumps.
FIGS. 9A-9F show photographs of various stages of securing a copper wire to a photosintered copper bump.
FIG. 10 illustrates a compliant photosintered metallic bump.
The present invention provides the method of making a metallic conductor as defined in claim 1. The invention also provides a use of a metallic paste as defined in claim 9.

### DETAILED DESCRIPTION

Metallic compositions (e.g., inks and pastes) formulated for low temperature processing are suitable for use in the manufacturing of printed electronics, as conductive adhesives, or in other applications including the manufacture and assembly of various electrical components and circuits, such as electrodes and interconnects. The metallic compositions include metal nanoparticles (e.g., copper, nickel, silver, gold, aluminum, cobalt, molybdenum, zinc, and the like) in optically transparent vehicles suitable for photosintering. The nanoparticles in these composition may be selected according to size and passivation coating, and the composition may be formulated to allow precision printing. The nanoparticles in the printed composition may be cured (e.g., photosintered, thermally sintered, or both) into bulk metallic films or lines at temperatures compatible with plastic substrates.

Metallic compositions described herein are formulated to yield cured conductors with reduced amounts of organic residue from the liquid vehicle. The metallic compositions may be sintered (e.g., in less than about 5 msec, less than about 2 msec, or less than about 1 msec) to produce metallic conductors using a photosintering process. In this photosintering process, a high-intensity light pulse (e.g., about 50,000, 100,000, or 150,000 lux or higher) is absorbed by the metal nanoparticles in the composition and then converted into heat. As a result, the metallic composition may be subjected to a short, high thermal pulse that rapidly evaporates organic components before these components undergo thermal oxidation or decomposition. This photosintering of metallic compositions (e.g., pastes and inks) yields conductors with high conductivity that may be formed at lower temperatures, and lower resistivities than some thermal sintering processes alone.

In some embodiments, the metallic compositions described herein may be formulated such that photosintering and/or thermal sintering of the composition on a polymer substrate (e.g., in air or in a forming gas) provides conductors that have a lowered resistivity. For example, copper conductors made from copper pastes described herein may have a resistivity between about 1 x 10⁻³ Ω·cm and about 1 x 10⁻⁶ Ω·cm. That is, the copper conductors may have a resistivity of less than about 1 x 10⁻³ Ω·cm, less than about 1 x 10⁻⁴ Ω·cm, less than about 1 x 10⁻⁵ Ω·cm, or greater than about 1 x 10⁻⁶ Ω·cm.

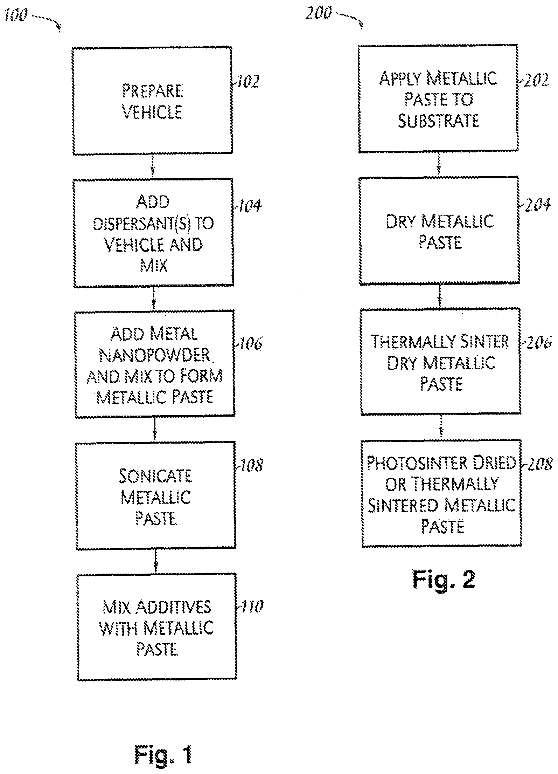

An example of preparation of metallic compositions used to form conductors with high conductivity (low resistivity) is illustrated in FIG. 1. Preparation 100 may be performed in an inert atmosphere. In step 102, a desired amount (e.g., volume) of the liquid vehicle is prepared. The liquid vehicle may include, for example, aromatics, aliphatic ketones and alcohols, esters, and any combination thereof. If the vehicle includes more than one component, the components may be mixed together. In step 104, one or more dispersants may be added to the vehicle, and the mixture agitated (e.g., stirred, shaken, mixed, sonicated, or the like) to achieve homogeneity. Dispersants may include, for example, short chain polymeric amines, alcohols, sulfonates, phosphates, and any combination thereof. In step 106, an amount of metal nanoparticles (e.g., in the form of a nanopowder) may be added to the vehicle to achieve the desired copper loading. In some embodiments, the nanopowder may be about 30 wt% to about 70 wt%, or about 50 wt% to about 80 wt%, of the composition. This heterogeneous mixture is then agitated to form a paste. In step 108, the paste may be sonicated to form a homogeneous dispersion. The sonication may be achieved with low energy and short duration (e.g., for less than about 10 minutes, about 2 to 8 minutes, or about 5 minutes). The sonication bath liquid may be cooled (e.g., to about 0°C). If the sonication time is too long, or the sonication energy is too high, cavitation may cause localized heating to unacceptably high temperatures, leading to aggregation or agglomeration of the metal nanoparticles. Inhibition of aggregation or agglomeration of the metal nanoparticles may be facilitated by cooling the metallic paste (e.g., to about 0°C) during the sonication procedure. Aggregation or agglomeration of the metal nanoparticles can lead to larger particle sizes and lowered performance in the sintering step. Aggregation can be problematic for copper nanoparticles, because copper-copper chemical bond formation may occur. These copper-copper bonds may not be broken by subsequent mechanical action. In step 110, additives selected to adjust properties such as viscosity, wetting, or contact angle may be added and mixed with the paste. The additives may be covalent compounds, ionic compounds, or any combination thereof.

A metallic paste prepared as described in FIG. 1 may be formed into a conductor (e.g., a conductive film) by a photosintering process. For example, the metallic paste may be coated onto a substrate (e.g., a KAPTON® polyimide film available from DuPont) by a drawdown process. The photosintering process may include a pre-drying step prior to the light flash that photosinters the metal nanoparticles into, for example, a metallic film. For example, the coating may be dried at about 100°C in air for about 60 min. This step promotes removal of volatile components from the printed paste. If the volatile components are allowed to remain in the paste, rapid vaporization during the photosintering step may cause metal nanoparticles to be blown off the substrate. After drying, the resistivity of the dried paste may be, for example, as high as 100 Ω·cm. In some embodiments, drying time may be reduced by using a higher temperature, carrying out the drying step under vacuum, or heating under infrared or microwave radiation. For copper pastes that do not contain volatile liquid components, the drying step may be eliminated to reduce the processing time.

The dried paste may be cured in a forming gas or in air. For example, the dried paste may be thermally sintered for about 60 min at about 350°C in a mixture of up to about 10 vol% hydrogen in nitrogen (e.g., about 3-5 vol% hydrogen in nitrogen). For a copper paste with nanoparticles in a range of about 20 nm to about 200 nm, a resistivity of the thermally sintered film may be about 3 x 10⁻⁴ Ω·cm. The forming gas may reduce copper oxides in the dried paste to copper. For example, the hydrogen component in the forming gas reacts with the copper oxides to form copper and water as shown below:

CuO + H₂ → Cu + H₂O

and

Cu₂O + H₂ → 2Cu + H₂O

The water vapor can be carried off in the forming gas.

The thermally sintered metallic composition may be photosintered in a forming gas or in air to reduce its resistivity. Photosintering includes subjecting the metallic composition to a flash of light. The intensity (as measured by the voltage) and duration (as measured by the pulse width) of the light flash may be selected to reduce blow off of the metal particles from the substrate, to reduce resistivity of the resulting conductor, and to increase adhesion of the resulting conductor to the substrate. In an example, after photosintering of a thermally sintered copper conductor in air, a thickness of the conductor may be about 1 µm, and a resistivity of the conductor may be about 2 x 10⁻⁵ Ω·cm.

A metallic paste may be dried in air or in an inert atmosphere. A metallic paste, or a dried metallic paste, may be thermally cured to form a metallic conductor. The thermally sintered conductor may be photosintered to reduce the resistivity of the conductor. In some cases, a dried metallic paste can be photosintered without undergoing thermal sintering. FIG. 2 illustrates a process 200 for forming a low resistivity conductor from a metallic composition. In step 202, a metallic paste is applied to a substrate. In step 204, the substrate may be heated (e.g., in an oven for about 60 min at about 100°C) to dry the paste. In step 206, the dried paste may be thermally sintered.

In an example, thermal sintering may include the following steps. A substrate with a dried metallic paste is loaded into a quartz tube at room temperature. The quartz tube is evacuated (e.g., to about 100 mTorr). The quartz tube may be heated (e.g., to about 350°C) and purged with a forming gas (e.g., about 4 vol% hydrogen mixed with nitrogen) until the temperature is stabilized. The coated substrate may be heated for about 60 min at 350°C. After the forming gas and heater are turned off, and the tube may be purged with an inert gas (e.g., nitrogen) to cool the substrate (e.g., to below 100°C). The substrate with the thermally sintered conductor may be removed from the quartz tube.

In step 208, the dried or thermally sintered metallic paste is photosintered. A high voltage flash xenon lamp is used for photosintering. Photosintering may be achieved at temperatures of less than about 100°C (e.g., ambient temperature, or about 20°C), to yield a conductor with reduced electrical resistivity and increased adhesion to the substrate. U.S. Patent Application Publication No. 2008/0286488,
describes a photosintering process.

A comparison between photosintering and thermal sintering is shown in Table 1.

**Table 1. Comparison between photosintering and thermal sintering.**

| | Thermal sintering | | | Photosintering | |
|---|---|---|---|---|---|
| | | | | (after thermal sintering in forming gas) | (after thermal sintering in air) |
| Substrate | Ceramic | Polyimide | Polyimide | Polyimide | Polyimide |
| Coating method | Blade | Drawdown | Draw down | Drawdown | Drawdown |
| Material | ANI-2 | ANI-1 | ANI-1 | ANI-1 | ANI-1 |
| Cu particle size (nm) | ∼200 | ∼50 | -50 | ∼50 | ∼50 |
| Drying temperature | 70°C | 100°C | 100°C | 100°C | 100°C |
| Drying time | 60min | 60 min | 60 min | 60 min | 60min |
| Curing temperature | 300°C | 100°C | | | |
| | 350°C | 200°C | 350°C | Ambient (∼20°C) | Ambient (∼20°C) |
| | 500°C | 300°C | | | |
| Curing gas | Forming gas (4 vol% H₂ in N₂) | Air | Forming gas (4 vol% H₂ in N₂) | Air | Air |
| Curing time | 60min | 60 | 60min | 1.2 msec | 1.2 msec |
| Resistivity (Ω·cm) | 4 x 10² (300°C) | | | | |
| | 2 x 10² (350°C) | 4.50 x 10³ | 3 x 10⁻⁴ | 2 x 10⁻⁵ | 2.00 x 10⁻⁴ |
| | 2 x 10⁻⁴ (500°C) | | | | |
| Final film thickness (µm) | ∼10 | ∼1 | ∼1 | ∼1 | -1 |

The formulations for copper pastes ANI-1 and ANI-2 are shown in Table 2.

**Table 2. Copper paste formulations.**

| Paste | Vehicle (wt%) | Solvent (wt%) | Cu material (wt%) | 3-roll mill | Viscosity (cP) | Dispersant | Additive |
|---|---|---|---|---|---|---|---|
| ANI-1 | None (0 wt%) | MMB¹ (29 wt%) | Copper nanopowder² (69 wt%) | Yes | 11,000 | 1.5% DISPERBYK®-111 | 0.5% DISPERBYK®-181 |
| ANI-2 | DJ B-715³ (12.5 wt%) | Terpineol (37.5 wt%) | Copper nano powder⁴ (50 wt%) | No | 16,000 | none | none |

| | | | | | | | |
|---|---|---|---|---|---|---|---|
| ¹ 3-methoxyl-3-methyl-1-butanol ² Mean diameter 50 nm ³ Daejoo organic vehicle from Daejoo Fine Chemical Co., LTD. (Korea) ⁴ Mean diameter 200nm | | | | | | | |

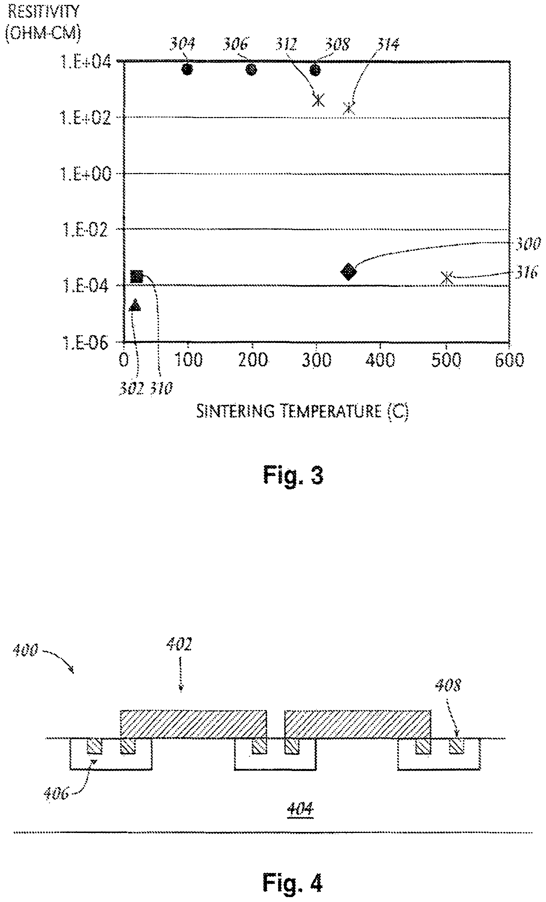

FIG. 3 shows resistivity (Ω·cm) vs. sintering temperature for the copper conductors in Table 1. Point 300 indicates a resistivity of about 3 x 10⁻⁴ Ω·cm for a conductor formed by thermally sintering copper paste ANI-1 in a forming gas environment. Point 302 indicates a resistivity of 2 x 10⁻⁵ Ω·cm for the conductive film formed by thermally sintering copper paste ANI-1 in a forming gas environment (point 300) followed by photosintering in air at about 20°C (1.2 msec, 1200 V). The photosintering step thus reduces the resistivity by about an order of magnitude.

Points 304, 306, and 308 indicate a resistivity of about 4.5 x 10³ Ω·cm for conductive films formed by thermally sintering copper paste ANI-1 in air at about 100°C, about 200°C, and about 300°C. Point 310 indicates a resistivity of about 2 x 10⁻⁴ Ω·cm for a conductive film formed by thermally sintering copper paste ANI-1 in air (points 304, 306, and 308) followed by photosintering in air at about 20°C (1.2 msec, 1200 V). The photosintering step thus reduces the resistivity by over seven orders of magnitude.

Points 312, 314, and 316 indicate resistivities of about 4 x 10² Ω·cm, about 2 x 10² Ω·cm, and about 2 x 10⁻⁴ Ω·cm for conductive films formed by thermally sintering ANI-2 paste (nanoparticle size 200 nm, no additives or dispersants) in a forming gas (4 vol% H₂ in N₂) at 300°C, 350°C, 500°C, respectively. Thus, FIG. 3 indicates that, below a certain temperature (e.g., about 400°C in some cases), photosintering can be used to achieve lower resistivities than can be achieved with thermal sintering alone.

In some embodiments, a dried metallic paste may be photosintered without an intermediate thermal sintering step. This may be advantageous for substrates damaged by higher Thermal sintering temperatures. Because of the low temperatures involved in the photosintering process (e.g., below 100°C), photosintering can be used to form conductors (with or without the use of a forming gas environment) with a resistivity in the order of 10⁻⁵ Ω·cm or less from metallic pastes and inks on substrates including polymers such as polyethylene, polyester, Flame Retardant 4, and the like, without damaging the substrate.

Metallic compositions (e.g., pastes or inks) may be used to make interconnects on printed circuit boards. FIG. 4 illustrates an assembly 400 having printed metal interconnects 402 formed with a photosintered metallic paste. The assembly 400 may include a substrate 404 (e.g., a silicon, ceramic or flexible organic substrate such as polyimide, polyester, liquid crystalline polymer, or the like) with two or more chips 406. Each chip 406 may have one or more metallic leads 408 that may be connected with other chip leads 408. Because the photosintering step can be carried out at low temperature, the metallic interconnects 402 may be directly coupled to the chip leads 408 to provide interconnections among the chips 406 assembled onto the substrate 404.

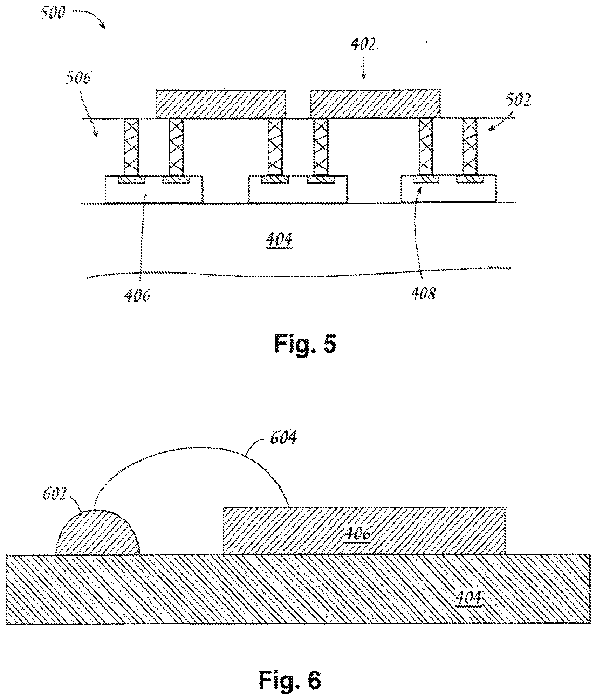

FIG. 5 illustrates an assembly 500 in which interconnects 402 formed from a photosintered metallic composition (e.g., paste or ink) arc used to fill vias 502 between chip metallic leads 408 and metallic interconnects 402. The substrate 404 (e.g., a silicon, ceramic or flexible organic substrate such as polyimide, polyester, liquid crystalline polymer, or the like) may include two or more chips 406 disposed thereon, each having one or more metallic leads 408. A conformal coating 506 may be printed onto the substrate 404 to cover the chips 406. Vias 502 to metallic chip leads 408 may be drilled and filled with the conductive copper paste. Copper interconnects 402 may then be printed onto the top of the vias 502, thereby connecting the chip leads 408. This process may be repeated in order to fabricate multi-layer circuits.

High viscosity copper pastes (e.g., about 10,000 cP to about 60,000 cP) may be prepared with high copper loadings (e.g., about 50 wt% to about 80 wt %) to allow for printing of thick lines. Thick lines with a low resistivity can carry high current density that may be required for many electronic devices. The copper pastes may be printed into the desired form of the interconnect features 402 in FIGS. 4 and 5 or used to fill the vias 502 in FIG. 5. The viscosity and wetting characteristics of the copper pastes may be modified for different interconnect dimensions or different via diameters and depths.

The metallic pastes described herein may be used to make multi-layer interconnections to reduce interconnect length and electrical resistance. As a result, a high density interconnect with lighter weight, smaller real estate, less noise and less loss on electrical signals can be formed to yield improved chip to chip connects. The metallic pastes described herein may also be used to eliminate wire bonding processes so as to increase performance and reliability of circuit design for chip to board interconnects, as well as removing the risk of tin whisker growth risk (and subsequent short circuiting) that can be caused by the use of lead-free solder. By using a metallic paste that can be directly deposited (e.g., screen printed) and photosintered, manufacturing of multi-layer boards is simpler and less costly.

In some cases, a conductive bump formed from a metallic paste or ink may be used to create an interface between an integrated circuit and other electronic circuitry. FIG. 6 illustrates an electronics device 600 in which substrate 404 supports integrated circuit 406. The integrated circuit 406 is electrically connected to a metallic bump 602 formed on the substrate 404. Metallic bump 602 is connected to integrated circuit 406 with wire 604. In some embodiments, metallic bump 602 is formed from a copper paste or ink, and wire 604 is a copper wire.

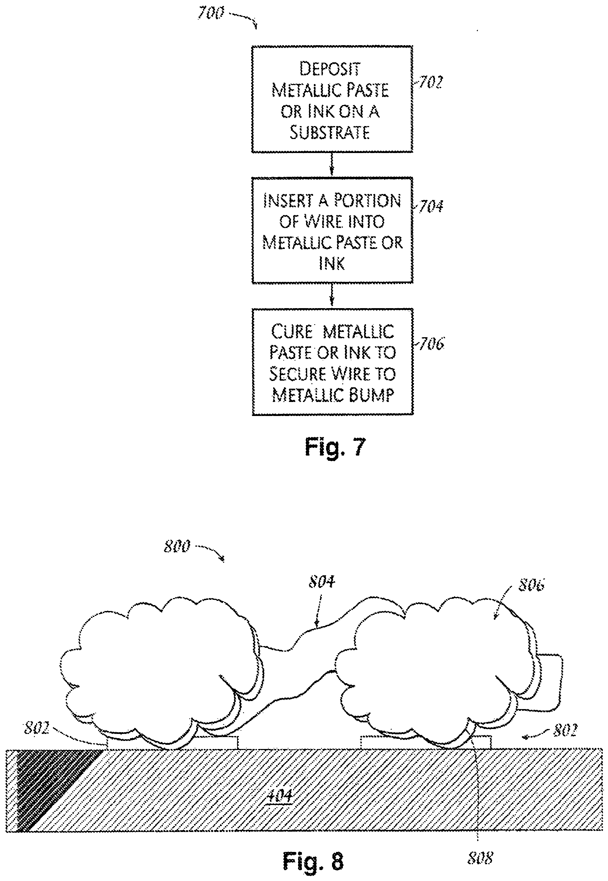

FIG. 7 illustrates a process 700 for forming the assembly in FIG. 6. In step 702, a droplet of metallic ink or paste is deposited on a substrate with a method selected according to a property of the ink or paste (e.g., viscosity). The substrate may be a polymer such as, for example, a polyimide. In step 704, a portion of the wire (e.g., an end of the wire) is inserted into the droplet. In step 706, the droplet 602 is cured (e.g., thermally sintered, photosintered, or the like). Another portion of the wire (e.g., the other end) may be secured, for example, to an integrated circuit. The photosintering promotes the elimination of metal oxide (by, for example, the reduction of to copper oxide to copper), together with the fusion of the metal nanoparticles into a metal bulk film. After the sintering step, the wire is secured in the solid metal bump, resulting in an electrical connection between the wire and the substrate to which the metal bump is adhered.

FIG. 8 illustrates a device 800 including conductive lines or pads 802 formed from a metallic ink or paste deposited onto a substrate 404 and photosintered. Conductive lines or pads may be, for example, about 0.1 µm thick. Substrate 404 may include a polymeric material, such as KAPTON®. Tape bonding wires 804 are positioned on top of the photosintered copper pads 802. The bonding wires 804 may be, for example, about 25 µmin diameter. Droplets of metallic ink or paste (e.g., about 40-60 µm in diameter) 806 are deposited on the conductive pad/bonding wire junction 808 and baked (e.g., for 30 min at 100°C) to dry the droplets. The droplets are then photosintered, and the resistance is measured through the wire junctions 808.

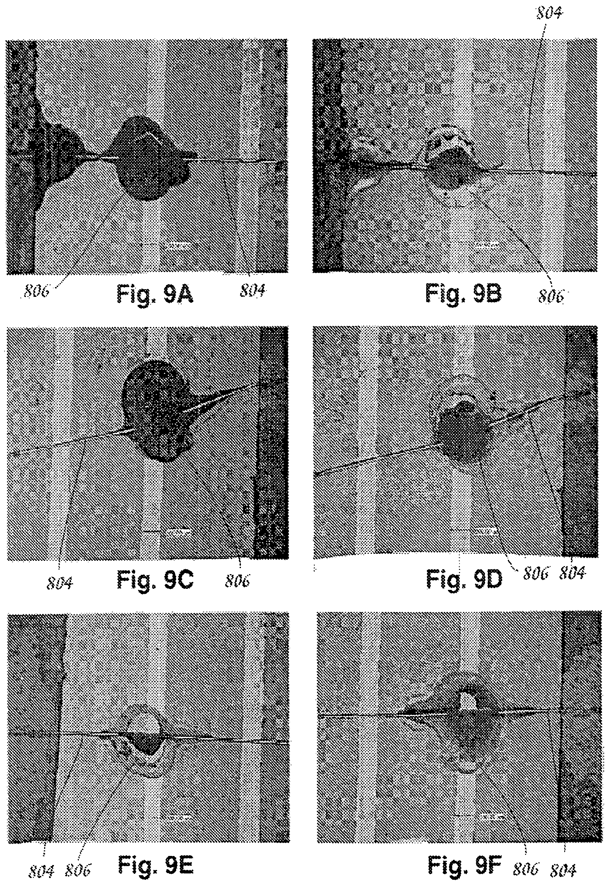

FIGS. 9A-9F are photographs of various stages in the process described with respect to FIG. 8. FIGS. 9A and 9C show copper wires 804 inserted in copper droplets 806 before photosintering. FIGS. 9B and 9D-F show the copper bumps 900 after photosintering.

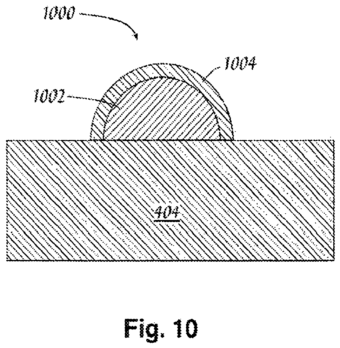

In some cases, as illustrated in FIG. 10, the metallic bumps may be compliant. Compliant bumps 1000 may be formed by depositing a compliant polymer material 1002 onto substrate 404. Then, metallic ink or paste 1004 is deposited over the polymer material 1002. A wire may be inserted into the metallic ink or paste 1004, and the droplet cured (e.g., photosintered) to secure the wire to the cured metallic conductor. This process may be performed at a temperature less than 100°C.

Manufacturing costs can be reduced when metallic bumps are formed of copper, for example, rather than gold, for several reasons. First, copper droplets can be positioned precisely with selected printing techniques (e.g., copper inks can be ink-jet printed). Second, since the copper bumps can be cured (e.g., photosintered) at less than 100°C, a wider array of substrate materials may be used without being damaged by a high-temperature process. Third, since the copper bumps can be cured at low temperatures, the sintering can occur in an air environment (rather than an inert environment), with minimal oxidation of the metal occurring during bonding between the chip pads and the conductive bumps.

It is to be understood that while the invention has been described in conjunction with the detailed description thereof, the foregoing description is intended to illustrate and not limit the scope of the invention, which is defined by the scope of the appended claims.

## Claims

1. A method of making a metallic conductor comprising curing a metallic paste comprising metal nanoparticles and with a viscosity of 10 Pa.s (10,000 cP) to 60 Pa.s (60,000 cP) to provide the metallic conductor, wherein the metallic conductor has a resistivity of about 5 x 10⁴ Ω·cm or less, **characterized in that** the curing comprises photosintering, wherein the photosintering comprises exposing the metal nanoparticles to a high voltage flash xenon lamp and the photosintering promotes the elimination of metal oxide, together with the fusion of the metal nanoparticles into a metal bulk film.

2. The method of claim 1, wherein the photosintering is achieved at temperatures of less than 100 °C, optionally at ambient temperature.

3. The method of claim 1, wherein the metallic paste comprises copper nanoparticles.

4. The method of claim 1, further comprising thermally sintering the metallic paste before the photosintering or further comprising thermally sintering the metallic paste in a forming gas before the photosintering.

5. The method of claim 1, wherein the curing further comprises thermally sintering the metallic paste before the photosintering.

6. The method of any preceding claim wherein the metallic paste includes metal nanoparticles in an optically transparent vehicle suitable for photosintering and the nanopowder is in an amount of 30 wt% to 70 wt%, or of 50 wt% to 80 wt%, of the paste.

7. The method of claim 6 wherein the paste is a homogeneous dispersion obtainable by sonication, e.g. at a temperature of 0°C and for a duration of less than 10 minutes.

8. The method of any preceding claim wherein the paste is a copper paste having a copper loading of 50 wt% to 80 wt%.

9. The use of a metallic paste comprising metal nanoparticles to form a conductor by photosintering, wherein the photosintering comprises exposing the metal nanoparticles to a high voltage flash xenon lamp and the photosintering promotes the elimination of metal oxide, together with the fusion of the metal nanoparticles into a metal bulk film, which paste has a viscosity of 10 Pa.s (10,000 cP) to 60 Pa.s (60,000 cP) and includes metal nanoparticles in an optically transparent vehicle suitable for photosintering, the nanoparticles being in an amount of 30 wt% to 70 wt%, or of 50 wt% to 80 wt%, of the paste.

10. The use of claim 9 wherein the metal nanoparticles are selected from copper, nickel, silver, gold, aluminum, cobalt, molybdenum and zinc.

11. The use of claim 9, wherein the technique further comprises thermally sintering the metallic paste before the photosintering.

12. The use of any of claims 9 to 11 wherein the nanoparticles are copper nanoparticles, e.g. having a size in a range of 20 nm to 200 nm, and optionally wherein the resultant copper conductor has a resistivity between 1 x 10⁻³ Ω·cm and 1 x 10⁻⁶ Ω·cm.

13. The use of any of claims 9 to 12 wherein the use further comprises drying the paste before photosintering and optionally wherein the dried paste is cured in a forming gas or in air.

14. The use of any of claims 9 to 13 wherein the paste is further as defined in paragraph a), in paragraph b) or by a combination of paragraphs a) and b):
a) the paste is a homogeneous dispersion obtainable by sonication, e.g. at a temperature of 0°C and for a duration of less than 10 minutes;
b) the paste is a copper paste having a copper loading of 50 wt% to 80 wt%.

## Patentansprüche

1. Verfahren zum Herstellen eines metallischen Leiters, umfassend ein Aushärten einer metallischen Paste umfassend Metallnanopartikel und mit einer Viskosität von 10 Pa.s (10.000 cP) bis 60 Pa.s (60.000 cP) zum Bereitstellen des metallischen Leiters, wobei der metallische Leiter einen Widerstand von ca. 5 x 10⁻⁴ Ω·cm oder weniger hat, **dadurch gekennzeichnet, dass** das aushärten ein Lichtsintern umfasst, wobei das Lichtsintern ein Aussetzen der Metallnanopartikel an eine Hochspannungsblitz-Xenonlampe umfasst und das Lichtsintern die Eliminierung von Metalloxid fördert, zusammen mit der Fusion der Metallnanopartikel in einen hauptsächlich aus Metall bestehenden Film.

2. Verfahren nach Anspruch 1, wobei das Lichtsintern bei Temperaturen von weniger als 100 °C erreicht wird, optional bei Umgebungstemperatur.

3. Verfahren nach Anspruch 1, wobei die metallische Paste Kupfernanopartikel umfasst.

4. Verfahren nach Anspruch 1, ferner umfassend ein thermisches Sintern der metallischen Paste vor dem Lichtsintern, oder ferner umfassend ein thermisches Sintern der metallischen Paste in einem Formiergas vor dem Lichtsintern.

5. Verfahren nach Anspruch 1, wobei das Aushärten ferner ein thermisches Sintern der metallischen Paste vor dem Lichtsintern umfasst.

6. Verfahren nach einem vorherigen Anspruch, wobei die metallische Paste Metallnanopartikel in einem optisch transparenten Vehikel enthält, das für Lichtsintern geeignet ist, und das Nanopulver in einer Menge von 30 Gew.-% bis 70 Gew.-%, oder von 50 Gew.-% bis 80 Gew.-% der Paste ist.

7. Verfahren nach Anspruch 6, wobei die Paste eine homogene Dispersion ist, die durch Beschallung erlangt werden kann, z. B. bei einer Temperatur von 0 °C und über eine Dauer von weniger als 10 Minuten.

8. Verfahren nach einem vorherigem Anspruch, wobei die Paste eine Kupferpaste mit einem Kupfergehalt von 50 Gew.-% bis 80 Gew.-% ist.

9. Verwendung der metallischen Paste umfassend Metallnanopartikel zum Bilden eines Leiters durch Lichtsintern, wobei das Lichtsintern ein Aussetzen der Metallnanopartikel an eine Hochspannungsblitz-Xenonlampe umfasst und das Lichtsintern und das Lichtsintern die Eliminierung von Metalloxid fördert, zusammen mit der Fusion der Metallnanopartikel in einen hauptsächlich aus Metall bestehenden Film, wobei die Paste eine Viskosität von 10 Pa.s (10.000 cP) bis 60 Pa.s (60.000 cP) hat und Metallnanopartikel in einem optisch transparenten Vehikel enthält, das zum Lichtsintern geeignet ist, wobei die Nanopartikel in einer Menge von 30 Gew.-% bis 70 Gew.-%, oder von 50 Gew.-% bis 80 Gew.-% der Paste sind.

10. Verwendung nach Anspruch 9, wobei die Metallnanopartikel ausgewählt sind von Kupfer, Nickel, Silber, Gold, Aluminium, Kobalt, Molybdän und Zink.

11. Verwendung nach Anspruch 9, wobei die Technik ferner ein Sintern der metallischen Paste vor dem Lichtsintern umfasst.

12. Verwendung nach einem der Ansprüche 9 bis 11, wobei die Nanopartikel Kupfernanopartikel sind, z. B. mit einer Größe im Bereich von 20 nm bis 200 nm, und optional wobei der resultierende Kupferleiter einen Widerstand zwischen 1 x 10⁻³ Ω·cm und 1 x 10⁻⁶ Ω·cm hat.

13. Verwendung nach einem der Ansprüche 9 bis 12, wobei die Verwendung ferner ein Trocknen der Paste vor dem Lichtsintern umfasst, und optional wobei die getrocknete Paste in einem Formiergas oder in Luft ausgehärtet wird.

14. Verwendung nach einem der Ansprüche 9 bis 13, wobei die Paste ferner wie definiert in Abschnitt a), in Abschnitt b) oder durch eine Kombination der Abschnitte a) und b) ist:
a) die Paste ist eine homogene Dispersion, die durch Beschallung erlangt werden kann, z. B. bei einer Temperatur von 0 °C und über eine Dauer von weniger als 10 Minuten;
b) die Paste ist eine Kupferpaste mit einem Kupfergehalt von 50 Gew.-% bis 80 Gew.-%.

## Revendications

1. Méthode de réalisation d'un conducteur métallique comprenant le durcissement d'une pâte métallique comprenant des nanoparticules métalliques, et présentant une viscosité comprise entre 10 Pa.s (10 000 cP) et 60 Pa.s (60 000 cP), pour obtenir le conducteur métallique, le conducteur métallique présentant une résistivité d'environ 5 x 10⁻⁴ Ω·cm ou moins, **caractérisée en ce que** le durcissement comprend un frittage par effet photochimique, le frittage par effet photochimique exposant les nanoparticules métalliques à une lampe éclair au xénon à haute tension, et le frittage par effet photochimique favorisant l'élimination de l'oxyde de métal, ainsi que la fusion des nanoparticules métalliques en une bande de film métallique.

2. Méthode selon la revendication 1, le frittage par effet photochimique étant réalisé à des températures inférieures à 100°C, en option à la température ambiante.

3. Méthode selon la revendication 1, la pâte métallique comprenant des nanoparticules de cuivre.

4. Méthode selon la revendication 1, comprenant en outre le frittage thermique de la pâte métallique préalablement au frittage par effet photochimique, ou comprenant en outre le frittage thermique de la pâte métallique dans un gaz de formage préalablement au frittage par effet photochimique.

5. Méthode selon la revendication 1, le durcissement comprenant en outre le frittage thermique de la pâte métallique préalablement au frittage par effet photochimique.

6. Méthode selon une quelconque des revendications précédentes, la pâte métallique comprenant des nanoparticules métalliques dans un véhicule optiquement transparent approprié pour le frittage par effet photochimique, et la nanopoudre étant présente dans la proportion allant de 30% en poids à 70 % en poids, ou de 50% en poids à 80 % en poids, de la pâte.

7. Méthode selon la revendication 6, la pâte étant une dispersion homogène pouvant être obtenue par sonication, p.ex. à la température de 0°C, et pendant une durée inférieure à 10 minutes.

8. Méthode selon une quelconque des revendications précédentes, la pâte étant une pâte de cuivre présentant une teneur en cuivre allant de 50% en poids à 80 % en poids.

9. Utilisation d'une pâte métallique comprenant des nanoparticules métalliques pour former un conducteur par frittage par effet photochimique, comprenant l'exposition des nanoparticules métalliques à une lampe éclair au xénon à haute tension, et le frittage par effet photochimique favorisant l'élimination de l'oxyde de métal, ainsi que la fusion des nanoparticules métalliques en une bande de film métallique, laquelle pâte présentant une viscosité comprise entre 10 Pa.s (10 000 cP) et 60 Pa.s (60 000 cP), et comprenant des nanoparticules métalliques dans un véhicule optiquement transparent approprié pour le frittage par effet photochimique, et les nanoparticules étant présentes dans la proportion allant de 30% en poids à 70 % en poids, ou allant de 50% en poids à 80 % en poids, de la pâte.

10. Utilisation selon la revendication 9, les nanoparticules métalliques étant sélectionnées parmi les suivantes : cuivre, nickel, argent, or, aluminium, cobalt, molybdène et zinc.

11. Utilisation selon la revendication 9, la technique comprenant en outre le frittage thermique de la pâte métallique préalablement au frittage par effet photochimique.

12. Utilisation selon une quelconque des revendications 9 à 11, les nanoparticules étant des nanoparticules de cuivre, à granulométrie comprise dans la plage 20 nm à 200 nm, par exemple, et, en option, le conducteur de cuivre résultant présentant une résistivité comprise entre 1 x 10⁻³ Ω·cm et 1 x 10⁻⁶ Ω·cm.

13. Utilisation selon une quelconque des revendications 9 à 12, l'utilisation comprenant en outre le séchage de la pâte préalablement au frittage par effet photochimique, et, en option, la pâte séchée étant durcie dans un gaz de formage ou à l'air.

14. Utilisation selon une quelconque des revendications 9 à 13, la pâte se présentant en outre selon la définition contenue dans le paragraphe a), dans le paragraphe b), ou dans une combinaison des paragraphes a) et b) :
a) la pâte est une dispersion homogène pouvant être obtenue par sonication, p.ex. à une température de 0°C, et pendant une durée inférieure à 10 minutes ;
b) la pâte étant une pâte de cuivre présentant une teneur en cuivre allant de 50 % en poids à 80 % en poids.
